# EUROPÄISCHE PATENTSCHRIFT

(11) **EP 3 233 566 B1**
(45) Veröffentlichungstag und Bekanntmachung des Hinweises auf die Patenterteilung: **08.04.2020**
(21) Anmeldenummer: 15801331.8
(22) Anmeldetag: 27.11.2015
(51) Int. Cl.: B60N 2/75, B60N 2/22, B60N 2/02

(54) **STEUERUNG EINER EINRICHTUNG ABHÄNGIG VON SITZNEIGUNG**
CONTROLLING OF A DEVICE DEPENDING ON INCLINATION OF A SEAT
LE CONTRÔLE D'UN DISPOSITIF EN FONCTION DE INCLINAION D'UN SIÈGE

(30) Priorität: 19.12.2014 DE 102014019125
(43) Veröffentlichungstag der Anmeldung: 25.10.2017
(73) Patentinhaber: Audi AG, 85045 Ingolstadt (DE)
(72) Erfinder: HELOT, Jacques, 85051 Ingolstadt (DE)
(86) Internationale Anmeldenummer: PCT/EP2015/002391
(87) Internationale Veröffentlichungsnummer: WO 2016/096090

(56) Entgegenhaltungen:
- EP-A1- 2 147 614
- DE-A1- 19 754 224
- US-A1- 2015 138 448

## Beschreibung

Die Erfindung betrifft ein Kraftfahrzeug mit einem Sitz, der eine Rückenlehne mit verstellbarer Lehnenneigung besitzt, einer Interieureinrichtung und einer steuerbaren Einrichtung. Darüber hinaus betrifft die vorliegende Erfindung ein Verfahren zum Betreiben eines entsprechenden Kraftfahrzeugs.

Fahrzeuge besitzen oftmals Bildschirme zur Unterhaltung der Fahrzeuginsassen. Solche Bildschirme werden beispielsweise auch für sogenannte "Rear-Seat Entertainmentsysteme" verwendet. Mit einem solchen System sollen die Insassen auf der Rückbank eines Kraftfahrzeugs komfortabel unterhalten werden. Für hohen Komfort kann außerdem vorgesehen sein, dass die Bildschirme dieses Systems direkt durch Bedienung oder durch eine Fernbedienung gesteuert werden können. Dabei haben die berührungssensitiven Bildschirme den Vorteil, dass die Bedienung intuitiver und einfacher gestaltet werden können. Fernbedienungen haben hingegen den Vorteil, dass auch eine Bedienung in größerer Entfernung vom Bildschirm möglich ist.

Bildschirme von "Rear-Seat Entertainmentsystemen" sind für die Insassen auf der zweiten und dritten Sitzreihe an der Hinterseite der jeweiligen Vordersitze angebracht. Wenn nun beispielsweise der Sitz auf der zweiten Sitzreihe nach hinten verschoben oder in eine Ruheposition gebracht wird, wird der Abstand der bedienenden Person zu dem Bildschirm zu groß, um ihn direkt durch Berührung zu bedienen. Es wäre hier also eine Fernbedienung erforderlich. Eine solche Fernbedienung hat jedoch den Nachteil, dass sie leicht verloren gehen kann und zusätzlich noch eine Ablage dafür im Interieur des Kraftfahrzeugs vorgesehen sein muss. Außerdem braucht man für die beiden Bildschirme in der zweiten Sitzreihe zwei Fernbedienungen.

Aus der Druckschrift DE 199 52 894 A1 ist eine versenkbare Monitor- oder Displayanordnung für Kraftfahrzeuge bekannt. Sie wird auf einen Schwenkarm montiert. Um hierbei zu erreichen, dass sie auch in einem Kraftfahrzeug einsetzbar ist, wird vorgeschlagen, dass zum Einbau im Bereich der Fondsitze bei Kraftfahrzeugen die Monitoranordnung samt Schwenkarmen in der nach vorne gerichteten Seite einer den Fontsitzen zugewiesenen Mittelarmlehne vollständig versenkbar bzw. aus derselben herausnehmbar ist. Ein gattungsgemässes Kraftfahrzeug und Verfahren sind aus der EP2147614 bekannt.

Die Aufgabe der vorliegenden Erfindung besteht somit darin, ein Kraftfahrzeug bereitzustellen, bei dem die Bedienung einer steuerbaren Einrichtung des Kraftfahrzeugs komfortabler erfolgen kann. Darüber hinaus soll ein entsprechendes Verfahren zum Betreiben eines Kraftfahrzeugs bereitgestellt werden.

Erfindungsgemäß wird diese Aufgabe gelöst durch ein Kraftfahrzeug mit einem Sitz, der eine Rückenlehne mit verstellbarer Lehnenneigung besitzt und/oder dessen Position in betriebsmäßig vorgesehener Vorwärtsfahrrichtung (X-Richtung) des Kraftfahrzeugs verstellbar ist, einer Interieureinrichtung und einer steuerbaren Einrichtung, wobei in oder an der Interieureinrichtung ein berührungsempfindlicher Bildschirm zur Steuerung der steuerbaren Einrichtung angeordnet ist, dessen Neigung, Krümmung und/oder Position in betriebsmäßig vorgesehener Vorwärtsfahrrichtung (X-Richtung) des Kraftfahrzeugs relativ zu der Interieureinrichtung verstellbar ist, und eine Steuereinrichtung des Kraftfahrzeugs dazu ausgelegt ist, die Neigung, Krümmung und/oder Position des berührungsempfindlichen Bildschirms in Abhängigkeit von der Lehnenneigung der Rückenlehne und/oder der Position des Sitzes in Vorwärtsfahrrichtung (X-Position) zu steuern. Darüber hinaus wird erfindungsgemäß bereitgestellt ein Verfahren zum Betreiben eines Kraftfahrzeugs mit einem Sitz, der eine Rückenlehne mit verstellbarer Lehnenneigung besitzt und/oder dessen Position in betriebsmäßig vorgesehener Vorwärtsfahrrichtung (X-Richtung) des Kraftfahrzeugs verstellbar ist, und einer Interieureinrichtung, durch Bereitstellen eines berührungsempfindlichen Bildschirms zur Steuerung der steuerbaren Einrichtung in oder an der Interieureinrichtung, dessen Neigung, Krümmung und/oder Position in betriebsmäßig vorgesehener Vorwärtsfahrrichtung (X-Richtung) des Kraftfahrzeugs relativ zu der Interieureinrichtung verstellbar ist, und Steuern der Neigung, Krümmung und/oder Position des berührungsempfindlichen Bildschirms in Abhängigkeit von der Lehnenneigung der Rückenlehne und/oder der Position des Sitzes in Vorwärtsfahrrichtung (X-Position).

In vorteilhafter Weise ist es entsprechend der vorliegenden Erfindung also vorgesehen, dass ein berührungsempfindlicher Bildschirm (Touch Display) als Fernbedienung für eine steuerbare Einrichtung verwendet wird, wobei die Neigung, Krümmung bzw. X-Position des berührungsempfindlichen Bildschirms abhängig gemacht wird von der Neigung der Rückenlehne des Sitzes und/oder X-Position des Sitzes in dem Kraftfahrzeug, von dem aus ein Nutzer die steuerbare Einrichtung bedienen will. Vorzugsweise ändert sich die Neigung des berührungsempfindlichen Bildschirms in der gleichen Richtung bzw. Weise wie diejenige der Rückenlehne des Sitzes. Somit kann nicht nur der Blickwinkel der bedienenden Person auf den berührungsempfindlichen Bildschirm in einem gewissen Bereich gehalten werden, sondern es kann auch dem Umstand Rechnung getragen werden, dass durch das Zurückneigen der Rückenlehne die Arme des Nutzers ebenfalls nach hinten wandern und so den berührungsempfindlichen Bildschirm unter Umständen nicht mehr so leicht erreichen. Letzterem wird dadurch entgegengewirkt, dass zumindest ein Teil des berührungsempfindlichen Bildschirms korrespondierend zu der Rückenlehne ebenfalls nach hinten oder vorne bewegt wird. Dementsprechend kann sich die Neigung des ganzen oder eines Teils des Bildschirms bzw. dessen Krümmung (insbesondere dessen Krümmungsradius) in Abhängigkeit von der Lehnenneigung der Rückenlehne verändern. Die Neigung kann beispielsweise auf die Vorwärtsfahrrichtung des Kraftfahrzeugs oder relativ zu einer Interieureinrichtung des Fahrzeugs bezogen sein.

In einer Ausführungsform handelt es sich bei der Interieureinrichtung um eine Mittelkonsole zwischen dem Sitz und einem weiteren Sitz des Kraftfahrzeugs mit verstellbarer Rückenlehne. In diesem Fall kann der berührungsempfindliche Bildschirm von beiden Sitzen aus als Fernbedienung für die steuerbare Einrichtung genutzt werden.

Darüber hinaus kann das Kraftfahrzeug mit einer Detektionseinrichtung ausgestattet sein, um zu erfassen, von welchem der Sitze aus eine Bedienhandlung des berührungsempfindlichen Bildschirms erfolgt, und die Steuereinrichtung des Kraftfahrzeugs kann dazu ausgelegt sein, die Neigung und/oder Krümmung des berührungsempfindlichen Bildschirms in Abhängigkeit von einer Lehnenneigung einer Rückenlehne desjenigen der Sitze zu steuern, von dem aus die Bedienhandlung erfolgt. Dadurch wird also automatisch die Neigung und/oder Krümmung des ganzen oder eines Teils des berührungsempfindlichen Bildschirms automatisch abhängig gemacht von demjenigen Sitz, von dem aus die Bedienhandlung vorgenommen wird. Dies lässt sich beispielsweise dadurch realisieren, dass mit einer Kamera oder einer Lichtschranke erkannt wird, aus welcher Richtung der berührungsempfindliche Bildschirm berührt werden wird. Dementsprechend wird der berührungsempfindliche Bildschirm neu positioniert oder geschwenkt bevor er überhaupt berührt wird.

Die Interieureinrichtung, relativ zu der die Neigung bzw. Krümmung des berührungsempfindlichen Bildschirms eingestellt wird, kann alternativ auch eine Türverkleidung oder ein Dachmodul sein. Im Falle der Türverkleidung besitzt also vorzugsweise jede Seitentür einen eigenen berührungsempfindlichen Bildschirm, sodass eine Bedienung der steuerbaren Einrichtung individuell von jedem Sitz aus an der bezüglich des jeweiligen Sitzes nach außen gewandten Seite aus bedient werden kann. Eine spezielle Erkennung, von welcher Seite aus der berührungsempfindliche Bildschirm bedient wurde, wie dies bei der Unterbringung in der Mittelkonsole notwendig ist, wäre in diesem Fall nicht notwendig. Es wäre hier vorteilhaft, wenn das Display, d.h. der berührungsempfindliche Bildschirm, in der Tür normalerweise (im unbenutzten Zustand) flach liegt und bei Annäherung aus der Tür heraus geschwenkt oder gefahren wird.

Für den Fall, dass es sich bei der Interieureinrichtung um ein Dachmodul handelt, kann der berührungsempfindliche Bildschirm oder ein Teil davon in Abhängigkeit von der Neidung der Rückenlehne des Sitzes beispielsweise aus dem Dachhimmel herausgeneigt werden. In diesem Fall würde der berührungsempfindliche Bildschirm oder ein Teil davon umso steiler eingestellt werden, je steiler die Rückenlehne des Sitzes steht. Wenn sich die Rückenlehne in Ruheposition befindet, könnte der berührungsempfindliche Bildschirm nahezu parallel zu dem Dachhimmel stehen. Der berührungsempfindliche Bildschirm ist also umso weiter aus dem Dachhimmel ausgefahren bzw. ausgeschwenkt, je steiler die Sitzlehne gegenüber der Vorwärtsfahrrichtung steht.

Besonders vorteilhaft ist, wenn es sich bei dem berührungsempfindlichen Bildschirm um einen OLED-Bildschirm handelt. Derartige Bildschirme können sehr dünn ausgebildet sein und es sind keine teueren einkristallinen Materialien notwendig. Vielmehr werden organische, halbleitende Materialien zum Leuchten gebracht.

Der OLED-Bildschirm ist günstigerweise biegbar ausgestaltet. Dies lässt sich insbesondere dann realisieren, wenn der Bildschirm in Dünnschichttechnologie aufgebaut ist.

In einer besonders bevorzugten Ausgestaltung handelt es sich bei der steuerbaren Einrichtung um einen von dem berührungsempfindlichen Bildschirm körperlich getrennten weiteren Bildschirm. Es wird also der weitere Bildschirm von dem berührungsempfindlichen Bildschirm gesteuert. Der berührungsempfindliche Bildschirm stellt also eine Fernbedienung für den weiteren Bildschirm dar.

Auch der weitere Bildschirm kann ein OLED-Bildschirm sein, der sehr dünn ausgestaltet werden kann.

Des Weiteren kann es sich bei dem weiteren Bildschirm um ein Teil eines Rücksitz-Unterhaltungssystems ("Rear-Seat Entertainmentsystem") handeln. Derartige Unterhaltungssysteme sind weit verbreitet und können somit von der vorliegenden Erfindung Gebrauch machen. Die Erfindung kann aber auch beispielsweise für den Beifahrersitz und ggf. sogar für den Fahrersitz genutzt werden, wobei sich dann der bewegbare Bildschirm in der Mittelkonsole vorne befinden kann.

Die oben in Zusammenhang mit dem beanspruchten Kraftfahrzeug angeführten Merkmale können auch dazu genutzt werden, um das beanspruchte Verfahren weiterzubilden. Die entsprechenden Verfahrensmerkmale ergeben sich aus den Funktionen, die die jeweiligen Vorrichtungsmerkmale erfüllen.

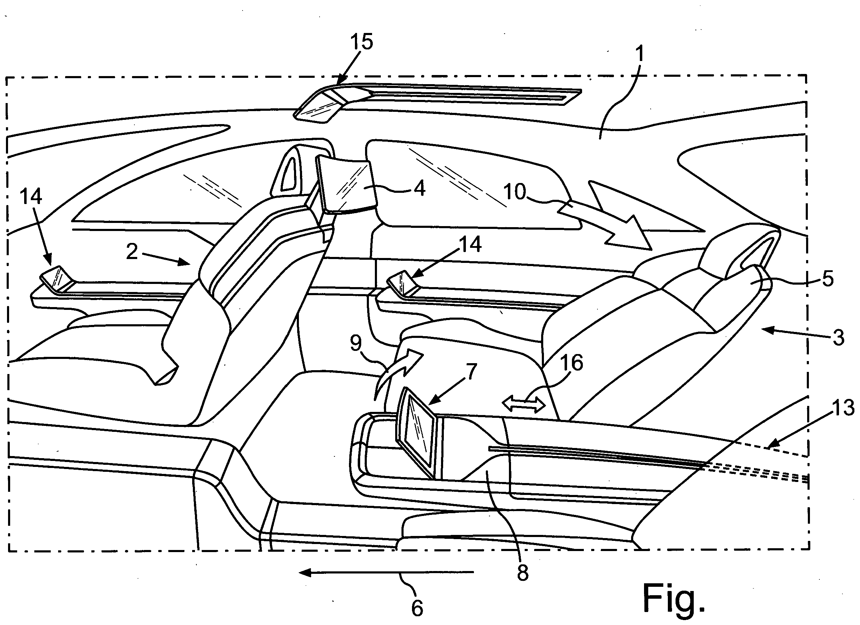

Die vorliegende Erfindung wird nun anhand der beigefügten Zeichnung näher erläutert, die einen Ausschnitt eines Innenraums eines Kraftfahrzeugs mit dem berührungsempfindlichen Bildschirm und der Verstellbarkeit seiner Neigung bzw. Krümmung zeigt.

Die nachfolgend näher geschilderten Ausführungsbeispiele stellen bevorzugte Ausführungsformen der vorliegenden Erfindung dar. Dabei ist zu beachten, dass die Merkmale nicht nur in den angeführten Kombinationen, sondern auch in Alleinstellung oder in anderen, technisch sinnvollen Kombinationen realisiert werden können.

In der einzigen Figur ist ein Teil eines Innenraums eines beispielhaften Kraftfahrzeugs dargestellt. Es ist ein Teil des Dachhimmels 1 zu erkennen sowie ein Beifahrersitz 2 und ein dahinter angeordneter Fontsitz 3. An der Rückenlehne des Beifahrersitzes 2 ist hier ein Bildschirm 4 angebracht, der zur Unterhaltung einer Person dient, die auf dem Rücksitz 3 sitzt. Dieser Bildschirm 4 stellt ein Beispiel für eine steuerbare Einrichtung dar. Alternativen für eine solche steuerbare Einrichtung wären die Klimaanlage, die Beleuchtung, das Radio, etc. des Kraftfahrzeugs.

Im vorliegenden Fall soll jedoch der Bildschirm 4 (im vorliegenden Dokument auch "weiterer Bildschirm" genannt) bedient bzw. gesteuert werden. Bei diesem Bildschirm 4 kann es sich um einen OLED-Bildschirm (Organic Light Emitting Diode) mit organischer Leuchtschicht handeln. Ein solcher Bildschirm 4 kann ggf. gebogen sein und/oder von der Hinterseite des Beifahrersitzes 2 abgenommen werden.

Die Rückenlehne 5 des Rücksitzes 3 ist schwenkbar. Dies bedeutet, dass die Neigung der Rücklehne 5 relativ zur Vorwärtsfahrrichtung 6 des Kraftfahrzeugs verstellt werden kann. Wird die Rückenlehne 5 des Rücksitzes 3 nun nach hinten gelegt, so entfernen sich die Schultern und damit auch die Arme und Hände des auf dem Rücksitz 3 sitzenden Nutzers beispielsweise von dem Bildschirm 4. In der in der Figur dargestellten Ruheposition des Rücksitzes 3 ist dessen Rückenlehne 5 weit nach hinten geneigt. In dieser Position ist es für den Nutzer schwierig, den Bildschirm 4 direkt zu bedienen. Eine Fernbedienung soll hier vermieden werden, da sie leicht verloren gehen kann.

Zur Bedienung des Bildschirms 4 oder einer anderen steuerbaren Einrichtung des Kraftfahrzeugs ist daher ein berührungsempfindlicher Bildschirm 7 vorgesehen, der von dem Rücksitz 3 leicht erreicht werden kann, auch wenn die Rückenlehne 5 weit zurückgeneigt ist. Damit der Nutzer den berührungsempfindlichen Bildschirm 7 als Bedienelement besser einsehen kann, ist seine Neigung und/oder Krümmung relativ zu der Vorwärtsfahrrichtung 6 oder einer Interieureinrichtung verstellbar. Die Verstellung erfolgt durch eine Steuereinrichtung, welche in Abhängigkeit von der Neigung der Rückenlehne 5 die Neigung bzw. Krümmung des berührungsempfindlichen Bildschirms 7 steuert.

Der berührungsempfindliche Bildschirm 7 ist hier in eine Mittelkonsole 8 zwischen dem Rücksitz 3 und dem benachbarten Rücksitz 13 eingebaut. Der gesamte berührungsempfindliche Bildschirm 7 oder zumindest ein Teil davon ist gemäß Pfeil 9 aus der Mittelkonsole 8 nach oben bezogen auf die Vorwärtsfahrrichtung 6 schwenkbar. Handelt es sich bei dem berührungsempfindlichen Bildschirm um einen flachen Bildschirm, so kann dieser insgesamt nach oben geneigt werden in Bezug auf die Vorwärtsfahrrichtung 6 bzw. die Mittelkonsole 8, die hier diejenige Interieureinrichtung darstellt, in oder an welche der berührungsempfindliche Bildschirm 7 montiert ist. Es kann sich dabei aber auch um einen biegbaren, insbesondere einen OLED-Bildschirm handeln. In diesem Fall wird beispielsweise nur ein Teil des Bildschirms gemäß Pfeil 9 nach oben geneigt, oder es wird der Krümmungsradius, mit dem sich der Bildschirm 7 krümmt verkleinert, sodass sich dessen Kante nach oben und gegen die Vorwärtsfahrrichtung 6 bewegt. Prinzipiell kann die Biegekurve des Bildschirms 7 jede Gestalt annehmen, die beispielsweise von der Krümmbarkeit eines OLED-Bildschirms erlaubt ist. Darüber hinaus kann der Bildschirm 7, 14 optional auch parallel zur X-Richtung 6 gemäß Pfeil 16 in bzw. an der jeweiligen Interieureinrichtung verschiebbar sein.

Der Kerngedanke der vorliegenden Erfindung besteht, wie oben angedeutet wurde, darin, dass die Neigung und/oder Krümmung des berührungsempfindlichen Bildschirms 7 von der Neigung der Rückenlehne 5 eines Sitzes, hier des Rücksitzes 3, abhängig ist. Vorzugsweise bedeutet dies, dass der berührungsempfindliche Bildschirm 7 umso steiler gestellt wird, je flacher die Rückenlehne 5 angeordnet ist. Wenn sich also in dem Beispiel der Figur die Rückenlehne entsprechend Pfeil 10 nach hinten bewegt, sollte gleichzeitig die in Vorwärtsfahrrichtung 6 gelegene Kante des berührungsempfindlichen Bildschirms 7 entsprechend Pfeil 9 nach hinten oben bewegt werden. Vorzugsweise sind die beiden Bewegungen 9 und 10, nämlich die des berührungsempfindlichen Bildschirms 7 und die der Rückenlehne 5 mittels der Steuereinrichtung synchronisiert. Dabei ist es weiterhin von Vorteil, wenn beide Bewegungen 9 und 10 automatisiert ablaufen.

In der Ruheposition des Rücksitzes 3, wie sie in der Figur dargestellt ist, ist der berührungsempfindliche Bildschirm 7 damit verhältnismäßig steil aufgestellt, sodass der Nutzer auf dem Rücksitz 3 ruhend die Darstellungen auf dem berührungsempfindlichen Bildschirm 7 besser einsehen und entsprechende Schaltflächen leichter betätigen kann. Ist die Rückenlehne 5 hingegen steiler eingestellt, so kann der berührungsempfindliche Bildschirm 7 deutlich flacher bzw. weniger gekrümmt eingestellt werden, sodass der Nutzer ihn auch in dieser Sitzposition gut einsehen und bedienen kann. Typischerweise befindet sich auch vor dem zweiten Rücksitz 13 ein Bildschirm, der von dem dort sitzenden Nutzer bedient werden soll. Alternativ oder gleichzeitig sollte auch dieser Nutzer andere zu steuernde Einrichtungen mithilfe des berührungsempfindlichen Bildschirms 7, der auch von ihm erreicht werden kann, angesteuert werden können. Aus diesem Grund ist es erforderlich, dass die für beide Insassen vorgesehene Bedieneinheit, hier der berührungsempfindliche Bildschirm 7 auch von beiden Insassen individuell bedient werden kann. Hierzu kann beispielsweise vorgesehen sein, dass der jeweilige Insasse ein Betätigungsfeld auf seiner Seite des berührungsempfindlichen Bildschirms 7 betätigt, um diesem zu signalisieren, welche zu steuernden Geräte von der Bedienhandlung betroffen sind. Vorzugsweise wird jedoch automatisch detektiert, welcher Insasse bzw. Nutzer eine Bedienhandlung an den berührungsempfindlichen Bildschirm 7 vorgenommen hat. In dem Beispiel der Figur können Lichtschranken an der Mittelkonsole vorgesehen sein, die detektieren, von welcher Seite aus der berührungsempfindliche Bildschirm bedient wurde. Entsprechend dieser Auswertung wird dann beispielsweise der rechte Bildschirm 4 am Beifahrersitz 2 oder der Bildschirm am Fahrersitz angesteuert. Eine solche automatisch Zuordnung der Bedienhandlung zur jeweiligen Insassenseite kann auch durch Bildauswertung von Bildern erfolgen, die durch eine Innenraumkamera aufgenommen werden. Auch andere automatische Detektionssysteme sind denkbar, um die Bedienhandlung dem jeweiligen Insassen bzw. der jeweiligen Insassenseite des Kraftfahrzeuginnenraums zuzuordnen. Ggf. wären auch zwei baulich getrennte Bildschirme oder Bildschirmteile denkbar, die unabhängig voneinander jeweils in Abhängigkeit von dem zugeordneten Sitz in ihrer Neigung oder Krümmung verstellt werden.

Auch wenn in dem Beispiel der Figur die Abhängigkeit der Neigung bzw. Krümmung des berührungsempfindlichen Bildschirms 7 nur von der Neigung der Rückenlehne 5 des Rücksitzes 3 dargestellt ist, kann die Neigung und/oder Krümmung des berührungsempfindlichen Bildschirms 7 auch von der Neigung der Rückenlehne des daneben angeordneten Rücksitzes 13 abhängen. Die Neigung bzw. Krümmung des berührungsempfindlichen Bildschirms 7 kann auch hier automatisch an die Neigung (jeweils bezogen auf die Vorwärtsfahrrichtung) des Rücksitzes 13 automatisch angepasst werden, indem durch die oben genannte Detektionseinrichtung detektiert wird, dass die Bedienhandlung eben vom Rücksitz 13 und nicht vom Rücksitz 3 erfolgt ist.

Entsprechend einer alternativen Ausführungsform ist beispielsweise für jeden der Rücksitze 3 und 13 in einem jeweiligen Türmodul 14 ein entsprechender berührungsempfindlicher Bildschirm zur Bedienung einer jeweils zu steuernden Einrichtung integriert. In diesem Fall ist die Detektion derjenigen Person nicht notwendig, die die Bedienhandlung vornimmt, da dann ja eben keine gemeinsame Bedieneinrichtung für mehrere Sitze vorliegt.

Auch für alle übrigen Sitze im Kraftfahrzeug kann die Funktion genutzt werden, dass die Einstellung der Krümmung bzw. Neigung eines berührungsempfindlichen Bildschirms von der Neigung der Rückenlehne des jeweiligen Sitzes bezogen auf die Vorwärtsfahrrichtung bzw. bezogen auf ein entsprechendes Interieurteil vorgenommen wird. Darüber hinaus kann die Bedieneinrichtung in Form des berührungsempfindlichen Bildschirms auch in ein Dachmodul 15 in dem Dachhimmel 1 integriert sein. Auch in diesem Fall kann es sich um einen sitzbezogenen Bedienbildschirm oder einen gemeinsamen Bedienbildschirm für mehrere Sitze handeln. In jedem Fall kann so auf eine freie Fernbedienung verzichtet werden.

## Patentansprüche

1. Kraftfahrzeug mit
- einem Sitz (3), der eine Rückenlehne (5) mit verstellbarer Lehnenneigung besitzt und/oder dessen Position in betriebsmäßig vorgesehener Vorwärtsfahrrichtung (6) des Kraftfahrzeugs verstellbar ist,
- einer Interieureinrichtung (1, 8) und
- einer steuerbaren Einrichtung (4), wobei
- in oder an der Interieureinrichtung (1, 8) ein berührungsempfindlicher Bildschirm (7) zur Steuerung der steuerbaren Einrichtung (4) angeordnet ist, dessen Neigung, Krümmung und/oder Position in betriebsmäßig vorgesehener Vorwärtsfahrrichtung (6) des Kraftfahrzeugs relativ zu der Interieureinrichtung (1, 8) verstellbar ist, und
- eine Steuereinrichtung des Kraftfahrzeugs dazu ausgelegt ist, die Neigung, Krümmung und/oder Position des berührungsempfindlichen Bildschirms (7) in Abhängigkeit von der Lehnenneigung der Rückenlehne (5) und/oder der Position des Sitzes (3) in Vorwärtsfahrrichtung (6) zu steuern, **dadurch gekennzeichnet, dass** die steuerbare Einrichtung (4) ein von dem berührungsempfindlichen Bildschirm (7) körperlich getrennter weiterer Bildschirm ist.

2. Kraftfahrzeug nach Anspruch 1, wobei die Interieureinrichtung (1, 8) eine Mittelkonsole zwischen dem Sitz (3) und einem weiteren Sitz (13) des Kraftfahrzeugs mit verstellbarer Rückenlehne ist.

3. Kraftfahrzeug nach Anspruch 2, wobei eine Detektionseinrichtung in dem Kraftfahrzeug dazu ausgelegt ist, zu erfassen, von welchem der Sitze (3, 13) aus eine Bedienhandlung des berührungsempfindlichen Bildschirms (7) erfolgt, und die Steuereinrichtung des Kraftfahrzeugs dann dazu ausgelegt ist, die Neigung und/oder Krümmung des berührungsempfindlichen Bildschirms (7) in Abhängigkeit von einer Lehnenneigung einer Rückenlehne desjenigen der Sitze (3, 13) zu steuern, von dem aus die Bedienhandlung erfolgt.

4. Kraftfahrzeug nach Anspruch 1, wobei die Interieureinrichtung (1, 8) eine Türverkleidung oder ein Dachmodul ist.

5. Kraftfahrzeug nach einem der vorhergehenden Ansprüche, wobei der berührungsempfindliche Bildschirm (7) ein OLED-Bildschirm ist

6. Kraftfahrzeug nach Anspruch 5, wobei der OLED-Bildschirm biegbar ist.

7. Kraftfahrzeug nach einem der vorhergehenden Ansprüche, wobei der weitere Bildschirm ein OLED-Bildschirm ist.

8. Kraftfahrzeug nach einem der vorhergehenden Ansprüche, wobei der weitere Bildschirm ein Teil eines Rücksitz-Unterhaltungssystems ist.

9. Verfahren zum Betreiben eines Kraftfahrzeugs mit einem Sitz (3), der eine Rückenlehne (5) mit verstellbarer Lehnenneigung besitzt und/oder dessen Position in betriebsmäßig vorgesehener Vorwärtsfahrrichtung (6) des Kraftfahrzeugs verstellbar ist, und einer Interieureinrichtung (1, 8) sowie mit einer steuerbaren Einrichtung (4), aufweisend folgende Verfahrensschritte:
- Bereitstellen eines berührungsempfindlichen Bildschirms (7) zur Steuerung der steuerbaren Einrichtung in oder an der Interieureinrichtung (1, 8) dessen Neigung, Krümmung und/oder Position in betriebsmäßig vorgesehener Vorwärtsfahrrichtung (6) des Kraftfahrzeugs relativ zu der Interieureinrichtung (1, 8) verstellbar ist, und
- Steuern der Neigung, Krümmung und/oder Position des berührungsempfindlichen Bildschirms (7) in Abhängigkeit von der Lehnenneigung der Rückenlehne (5) und/oder der Position des Sitzes (3) in Vorwärtsfahrrichtung (6), **dadurch gekennzeichnet, dass** die steuerbare Einrichtung (4) als ein von dem berührungsempfindlichen Bildschirm (7) körperlich getrennter weiterer Bildschirm bereitgestellt wird.

## Claims

1. Motor vehicle with
- a seat (3), having a backrest (5) with adjustable backrest inclination and/or the position of which is adjustable in the normal intended forward direction of travel (6) of the motor vehicle,
- an interior device (1, 8) and
- a controllable device(4), wherein
- a touch-sensitive screen (7) for controlling the controllable device (4) is arranged in or on the interior device (1, 8), the inclination, curvature and/or position of which is adjustable relative to the interior device (1, 8) in the normal intended forward direction of travel (6) of the motor vehicle, and
- a control device in the motor vehicle is designed to control the inclination, curvature and/or position of the touch-sensitive screen (7) depending on the backrest inclination of the backrest (5) and/or the position of the seat (3) in the forward direction of travel (6), **characterised in that** the controllable device (4) is an additional screen, which is physically separated from the touch-sensitive screen (7).

2. Motor vehicle according to claim 1, wherein the interior device (1, 8) is a centre console between the seat (3) and a further seat (13) in the motor vehicle with an adjustable backrest.

3. Motor vehicle according to claim 2, wherein a detection device in the motor vehicle is designed to register from which of the seats (3, 13) a control action is performed on the touch-sensitive screen (7), and the control device in the motor vehicle is then designed to control the inclination and/or curvature of the touch-sensitive screen (7) depending on a backrest inclination of a backrest for the seat (3, 13) from which the control action is performed.

4. Motor vehicle according to claim 1, wherein the interior device (1, 8) is a door panel or a roof module.

5. Motor vehicle according to any of the preceding claims, wherein the touch-sensitive screen (7) is an OLED display.

6. Motor vehicle according to claim 5, wherein the OLED display is flexible.

7. Motor vehicle according to any of the preceding claims, wherein the additional screen is an OLED display.

8. Motor vehicle according to any of the preceding claims, wherein the additional screen is part of the rear seat entertainment system.

9. Method for operating a motor vehicle with a seat (3), having a backrest (5) with adjustable backrest inclination and/or the position of which is adjustable in the normal intended forward direction of travel (6) of the motor vehicle, and an interior device (1, 8) as well as with a controllable device (4), having the following method steps:
- Provision of a touch-sensitive screen (7) for controlling the controllable device in or on the interior device (1, 8), the inclination, curvature and/or position of which is adjustable relative to the interior device (1, 8) in the normal intended forward direction of travel (6) of the motor vehicle, and
- Control of the inclination, curvature and/or position of the touch-sensitive screen (7) depending on the backrest inclination of the backrest (5) and/or the position of the seat (3) in the forward direction of travel (6), **characterised in that** the controllable device (4) is provided as an additional screen, which is physically separated from the touch-sensitive screen (7).

## Revendications

1. Véhicule automobile avec
- un siège (3), qui dispose d'un dossier (5) à inclinaison de dossier réglable et/ou dont la position est réglable dans le sens de la marche avant (6) prévu fonctionnellement du véhicule automobile,
- un dispositif d'intérieur (1, 8) et
- un dispositif commandable (4),
dans lequel
- un écran tactile (7) pour la commande du dispositif commandable (4), dont l'inclinaison, la courbure et/ou la position est réglable dans le sens de la marche avant (6) prévu fonctionnellement du véhicule automobile par rapport au dispositif d'intérieur (1, 8), est agencé dans ou au niveau du dispositif d'intérieur (1, 8), et
- un dispositif de commande du véhicule est conçu pour commander l'inclinaison, la courbure et/ou la position de l'écran tactile (7) en fonction de l'inclinaison de dossier du dossier (5) et/ou de la position du siège (3) dans le sens de la marche avant (6), **caractérisé en ce que** le dispositif commandable (4) est un autre écran séparé corporellement de l'écran tactile (7).

2. Véhicule automobile selon la revendication 1, dans lequel le dispositif d'intérieur (1, 8) est une console médiane entre le siège (3) et un autre siège (13) du véhicule automobile à dossier réglable.

3. Véhicule automobile selon la revendication 2, dans lequel un dispositif de détection dans le véhicule automobile est conçu pour détecter à partir duquel des sièges (3, 13) une manipulation de l'écran tactile (7) a lieu, et le dispositif de commande du véhicule automobile est alors conçu pour commander l'inclinaison et/ou la courbure de l'écran tactile (7) en fonction d'une inclinaison de dossier d'un dossier du siège (3, 13) à partir duquel a eu lieu la manipulation.

4. Véhicule automobile selon la revendication 1, dans lequel le dispositif d'intérieur (1, 8) est un habillage de porte ou un module de toit.

5. Véhicule automobile selon l'une quelconque des revendications précédentes, dans lequel l'écran tactile (7) est un écran OLED.

6. Véhicule automobile selon la revendication 5, dans lequel l'écran OLED est flexible.

7. Véhicule automobile selon l'une quelconque des revendications précédentes, dans lequel l'autre écran est un écran OLED.

8. Véhicule automobile selon l'une quelconque des revendications précédentes, dans lequel l'autre écran fait partie d'un système de divertissement de siège arrière.

9. Procédé pour faire fonctionner un véhicule automobile avec un siège (3), qui dispose d'un dossier (5) à inclinaison de dossier réglable et/ou dont la position est réglable dans le sens de la marche avant (6) prévu fonctionnellement du véhicule automobile, et un dispositif d'intérieur (1, 8) ainsi qu'avec un dispositif commandable (4), présentant les étapes de procédé suivantes :
- mise à disposition d'un écran tactile (7) pour la commande du dispositif commandable dans ou au niveau du dispositif d'intérieur (1, 8) dont l'inclinaison, la courbure et/ou la position est réglable dans le sens de la marche avant (6) prévu fonctionnellement du véhicule automobile par rapport au dispositif d'intérieur (1, 8), et
- commande de l'inclinaison, de la courbure et/ou de la position de l'écran tactile (7) en fonction de l'inclinaison de dossier du dossier (5) et/ou de la position du siège (3) dans le sens de la marche avant (6), **caractérisé en ce que** le dispositif commandable (4) est mis à disposition en tant qu'autre écran séparé corporellement de l'écran tactile (7).
